Europäisches Patentamt

European Patent Office

Office européen des brevets

(11) Publication number: **0 089 220**
**B1**

## EUROPEAN PATENT SPECIFICATION

(45) Date of publication of patent specification: **08.11.89**

(51) Int. Cl.⁴: **C 30 B 33/00,** C 03 C 25/02, G 02 B 6/16

(21) Application number: **83301399.8**

(22) Date of filing: **14.03.83**

(54) A crystalline fiber and a process for the production thereof.

(30) Priority: **16.03.82 JP 40254/82**
**16.03.82 JP 40255/82**
**16.03.82 JP 40256/82**

(43) Date of publication of application:
**21.09.83 Bulletin 83/38**

(45) Publication of the grant of the patent:
**08.11.89 Bulletin 89/45**

(84) Designated Contracting States:
**DE FR GB NL**

(56) References cited:
**EP-A-0 056 996**
**GB-A-2 016 731**
**US-A-4 253 731**

**IEEE Journal of Quantum Electronics, vol. 15 (1979), page 49D**

(73) Proprietor: **SUMITOMO ELECTRIC INDUSTRIES LIMITED**
**No. 15, Kitahama 5-chome Higashi-ku**
**Osaka-shi Osaka 541 (JP)**

(72) Inventor: **Murakami, Kazuhito C/O Osaka Works of Sumitomo**
**Electric Industries, Limited 1-3 Shimaya 1-Chome**
**Konohana-Ku Osaka (JP)**
Inventor: **Takahashi, Kenichi C/O Osaka Works of Sumitomo**
**Electric Industries, Limited 1-3 Shimaya 1-Chome**
**Konohana-Ku Osaka (JP)**

(74) Representative: **Allard, Susan Joyce et al**
**BOULT, WADE & TENNANT 27 Furnival Street**
**London EC4A 1PQ (GB)**

Courier Press, Leamington Spa, England.

## Description

This invention relates to infrared fibers and more particularly, it is concerned with infrared transmitting fibers consisting of crystalline metal halides and an improved process for the production thereof.

Various efforts have hitherto been made to prepare infrared fibers by processing optical crystals as described in "Nikkei Electronics" Dec. 8, 1980, page 140.

Above all, to guide light in a fiber, there have been proposed (1) a fiber structure of the loose clad type as disclosed in Japanese Patent Application OPI (Kokai) No. 145645/1978, in which an extruded fiber is loosely inserted in a tube, the crystalline fiber being used as a core and air being used as a cladding and (2) a fiber structure of the step index type as disclosed in Japanese Patent Application OPI (Kokai) No. 143242/1979, in which the circumference of a core crystal is coated in the molten state with a glass having a large viscosity and then subjected to spinning to form a fiber clad with the glass. In addition, U.S. Patent No. 4253731 describes a fiber structure (3) of the step index type prepared by extruding simultaneously a core crystal and a cladding crystal.

The accompanying drawings illustrate the principle and the merits of the present invention in greater detail.

Fig. 1 is a schematic view of an apparatus for extruding a core crystalline fiber according to the prior art.

Fig. 2(a) and (b) are respectively a cross-sectional view and longitudinally sectional view of the prior art infrared fiber.

Fig. 3 and Fig. 4 are cross-sectional views of crystalline fibers as embodiments of the present invention.

Fig. 5 is a schematic view of an extrusion apparatus of combination type, used for making a cladding crystalline pipe for the crystalline fiber according to the present invention.

Fig. 6(a) is a cross-sectional view of a combination die (die) 14 of Fig. 5, and Fig. 6(b) and (c) are respectively a cross-sectional view and side view of a combination die (porthole) 15 of Fig. 5, the cross-sectional view (b) being along chain lines A and B in Fig. 6(c).

Fig. 7 is a schematic view of an extrusion apparatus for inserting a core crystalline fiber during manufacture of a cladding crystalline pipe according to the present invention.

Fig. 8 is a cross-sectional view to illustrate the state of pipe drawing using a die.

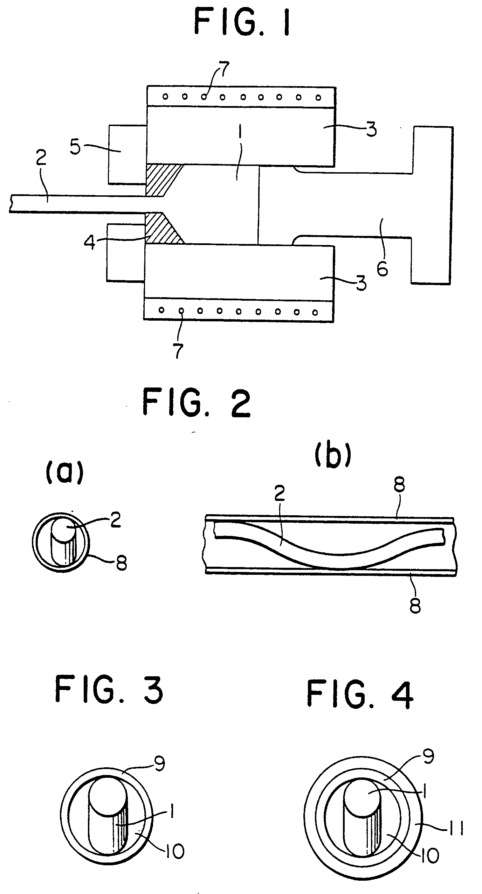

The above described fiber (1) of the prior art is prepared as follows. First, a crystalline core fiber is prepared by means of an apparatus for extruding a crystalline core fiber as shown in Fig. 1. That is to say, a core crystal 1 for an extrusion billet is charged into extrusion container 3 provided with a die 4, an extruding ram 6 and a die holder 5. Core crystal 1 is heated at a predetermined temperature by heater 7 and then extruding ram 6 is pressed by a hydraulic press to form core crystal fiber 2. The thus formed core crystal fiber 2 is loosely inserted in polymer pipe 8 as shown in Fig. 2; (a) of Fig. 2 being a cross-sectional view and (b) being a longitudinal sectional view. Polymers such as Teflon are not suitable for the transmission of a large input laser beam because of the large absorption loss of infrared rays resulting in a large loss at the contact area of the fiber and the polymer pipe.

The structure (2) of the prior art is mechanically weak due to the difference in thermal expansion between the crystalline core material and the glassy cladding material, resulting in strain in the fiber. Moreover, many glassy materials are not suitable for the transmission of long wave length infrared rays and result in large transmission losses when used as cladding layers for infrared fibers. Thus, the selection of a suitable cladding material is very restricted.

As in the case of structure (3) of the prior art, the method of coating a core crystal with a cladding crystal comprising simultaneously extruding the core crystal and cladding crystal has the disadvantage that it is difficult to obtain a fiber with a smaller diameter by further processing the core in a circular form because the interface between the core and the cladding tends to be disordered.

We have now developed an infrared fiber consisting of metal halides which has a mechanically and optically stable performance.

The fiber of the present invention has a descreased disorder at the interface between the core and cladding and a decreased transmission loss.

According to the present invention there is provided a crystalline fiber, in which a core crystal fiber for transmitting infrared rays is provided in a cladding crystal pipe having a smaller refractive index than the core crystal with a gap of 0.01 to 0.1 mm between the core crystal fiber and the cladding crystal pipe, the core crystal fiber and cladding crystal pipe being of crystalline materials selected from thallium halide, silver halide, alkali metal halide or mixed crystals thereof in such a combination as to provide the core crystal fiber with a larger refractive index than the cladding crystal pipe.

The present invention also provides a process for the production of a crystalline fiber, which comprises inserting a core crystal fiber into a cladding crystal pipe, subjecting the fiber and pipe to drawing through a die and thereby surrounding the core crystal fiber with the cladding crystal pipe such that there is a gap of 0.01 to 0.1 mm between the core crystal fiber and the cladding crystal pipe, the core crystal fiber and cladding crystal pipe being of crystalline materials selected from thallium halide, silver halide, alkali metal halide or mixed crystals thereof in such a combination as to provide the core crystal fiber with a larger refractive index than the cladding crystal pipe.

The present invention further provides a process for the production of a crystalline fiber, which

2

comprises preparing a cladding crystal pipe by extrusion and simultaneously inserting a core crystal fiber in the cladding crystal pipe such that there is a gap of 0.01 to 0.1 mm between the core crystal fiber and the cladding crystal pipe, the core crystal fiber and cladding crystal pipe being of crystalline materials selected from thallium halide, silver halide, alkali metal halide or mixed crystals thereof in such a combination as to provide the core crystal fiber with a larger refractive index than the cladding crystal pipe.

The infrared fiber produced according to the present invention has a decreased disorder at the interface between the core and the cladding and a low transmission loss.

According to the present invention a core crystalline fiber is inserted in a cladding crystalline pipe with a gap of 0.01 to 0.1 mm between the core crystalline fiber and the cladding crystalline pipe. If the gap between the core crystalline fiber and the cladding crystalline pipe is more than 0.1 mm, the effect of the cladding pipe is reduced, but if the gap is 0.1 mm or less, there is a tendency to lower the transmission loss. If drawing is further carried out to decrease the gap, the transmission loss can be reduced. However, when the gap is less than 0.01 mm, the core surface tends to be scratched and, accordingly, handling must be effected with great care. Thus, a gap of 0.01 mm or more should be present.

Materials which are used for the core crystal fiber and cladding crystal pipe are selected from thallium halides such as KRS-5, KRS-6, TlBr and TlCl, silver halides such as AgCl, AgBr and mixed crystals thereof, and alkali metal halides such as CsBr and CsI, from which suitable combinations of the core crystal and cladding crystal are chosen, the former having a larger refractive index than the cladding crystal in the infrared range.

Examples of combinations of the core crystal fiber and cladding crystal pipe are shown in the following table in which each possible combination is connected by a line:

| | Core | Cladding |
|---|---|---|
| Alkali Halide | Cesium Iodide ———————— | Cesium Bromide |
| Silver Halide | Silver Bromide | Silver Chloride |
| | Mixed Crystal Silver Bromide + 0.01—10 wt% Silver Chloride | Mixed Crystal Silver Chloride + 0.01—10 wt% Silver Bromide |
| Thallium Halide | Thallium Bromide | Thallium Chloride / KRS-6** |
| | KRS-5* | Thallium Bromide |

\*) KRS-5: mixed crystal of thallium iodide (45.7 mol%) and thallium bromide (54.3 mol%)
\*\*) KRS-6: mixed crystal of thallium bromide (29.8 mol%) and thallium chloride (70.2 mol%)

A cross-sectional view of the crystalline fiber of the present invention is shown in Figure 3, which comprises a core crystal fiber 1 for transmitting infrared rays, a cladding crystal pipe 9 having a smaller refractive index than the core crystal and a gap 10 between them. If necessary, the crystalline fiber of the present invention can further be coated with a protective monolayer or multilayer 11 of a resin or metal to prevent breakage or deformation due to external forces or from adhesion of dust as shown in Fig. 4. For example, lead, lead-tin alloys, aluminium and silver may be used as the metal and coated by extrusion. The resin may be an ABS resin, polybutadiene, polypropylene, polyethylene, polycarbonate, polyvinyl chloride, polyphenylene oxide, polysulfate or a mixture thereof, which are generally coated by melt extrusion, and polyesterimides, polyesters, polyurethanes, polyols, polyimide, polyamideimides, silicone resins, tetrafluoro resins, epoxy resins or a mixture thereof, which are generally coated by applying and baking.

The above described core crystal fiber of the crystalline fiber is generally prepared in known manner, for example, by extrusion molding.

The cladding crystal pipe is generally prepared by extrusion using a combination die system or a mandrel system, but in view of the strength and maintenance of a mandrel and the preparation of a small diameter pipe, the former system is preferable.

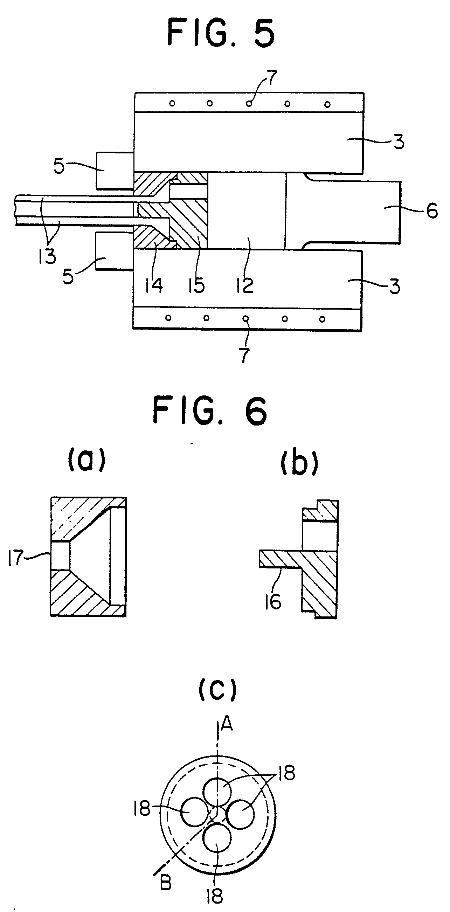

Fig. 5 shows a method of preparing a cladding crystal pipe by the extrusion molding of the combination die system, which comprises charging billet 12 of an optical crystal material for a cladding crystal pipe to an extrusion container 3 provided with a die 14, porthole 15, extrusion ram 6 and die holder 5, heating billet 12 by heater 7 and when it reaches a predetermined temperature, pressing extrusion ram 6 by a hydraulic press to form cladding crystal pipe 13.

Fig. 6(a) is a cross-sectional view of a combination die (die) 14 and Fig. 6(b) and (c) are respectively a cross-sectional view and side view of a combination die (porthole) 15, (b) being along chain lines A—B in Fig. 6 (c). 16 is a core defining the inner diameter of a pipe. A cladding crystal is extruded through holes 18 and passed through a gap between the porthole and die to form a tube.

3

Core crystal fiber 2 is inserted in cladding crystal pipe 13 to give a crystalline fiber as shown in Fig. 3.

The thus resulting infrared fiber comprising a core crystal fiber inserted in a cladding crystal pipe is superior to the prior art infrared fiber comprising a core crystal fiber loosely inserted in a polymer pipe made for example of Teflon as mentioned in (1) above in transmission loss since in the former, there is little loss at the contact area of the core crystal and cladding crystal.

In order to insert a core crystal fiber in a cladding crystal pipe, it is necessary to make the diameter of the pipe larger than that of the core. A core crystal fiber can be inserted batchwise in a cladding crystal pipe previously prepared as described above. However, the insertion of a core crystal fiber results in a tendency to scratch the surface of the soft core crystal fiber due to friction during the insertion, thus increasing the transmission loss. Thus, a core crystal fiber can be inserted in a pipe at the same time as the preparation of a cladding crystal pipe by extrusion.

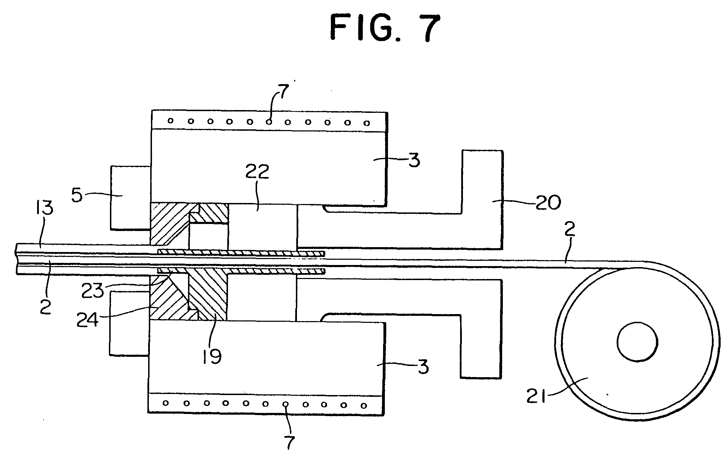

In Fig. 7 for example, an apparatus is shown for extruding a clad optic fiber. A previously hole-made cladding crystal 22 for an extrusion billet and combination die (porthole) 19 having a guide 23 for the core crystal fiber 2 is charged to extrusion container 3 and extruded to form cladding crystal pipe 13 by means of combination die 24 (die), die holder 5 and extrusion ram 20 which has a hole made to pass core crystal fiber 2.

The combination die (porthole) is provided with guide 23 consisting of a hollow protective shaft so that the core crystal fiber is not crushed by pressure applied during preparation of the cladding crystal pipe. The cladding crystal should therefore have a hole larger than the diameter of the guide. After heating at a predetermined temperature by heater 7, core crystal fiber 2 is passed through extrusion ram 20, and combination dies 19 and 24. This core crystal fiber can be prepared by the method as shown in Fig. 1, taken up round reel 21 and then fed, or can be extruded simultaneously with the extrusion of the cladding crystal pipe.

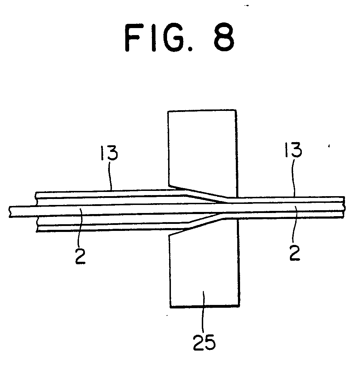

Fig. 8 shows schematically the state of drawing a pipe through a die. Core crystal fiber 2 is inserted in cladding crystal pipe 13 and then subjected to working through drawing die 25, during which a lubricating oil is applied to the surface of the cladding crystal pipe to uniformly decrease the friction between the die and pipe and to reduce the drawing force. When a core crystal fiber is inserted in a cladding crystal pipe, there is a gap between the pipe and fiber and, accordingly, only the cladding crystal pipe is worked and the gap is gradually decreased. When the gap is in the range of 0.01—0.1 mm, the core crystal fiber scarcely moves in the cladding crystal pipe and can resist an impulse or bending. At the same time, the pipe drawing is stopped.

The drawing of a cladding crystal pipe through a die is preferably carried out so as to decrease the deformation resistance of the crystal in a temperature range such that the pipe is hot or warm-worked, for example, at a temperature in the range of from 120 to 350°C for KRS-5, or 100 to 370°C for AgCl or 180 to 370°C for CsI.

Since metal halide crystals have small tensile strengths, it is desired that the reduction of area per one pass of die is adjusted to 20% or less so that the drawing force is not so large during pipe drawing.

Furthermore, in order to decrease the drawing force, it is preferable to use a lubricant, in particular, a liquid lubricant, for example, a mineral oil such as spindle oil, turbine oil or silicone oil or a fatty oil such as palm oil or whale oil. In pipe drawing at a high temperature, a heat resisting mineral oil, in particular, silicone oil is preferably used.

Because of the structure in which infrared rays are enclosed in a core and guided, the outside of the cladding layer can further be coated with a protective monolayer or multilayer of a metal or plastic to reinforce the infrared fiber, as in the case of ordinary optic fibers. The protective layer can increase the environmental resistance as well.

In the present position, a cladding crystal pipe can readily be prepared by the use of a combination die in a similar extrusion method to that of a core crystal fiber, and the core crystal fiber is inserted in the cladding crystal pipe to obtain a crystalline fiber with a decreased transmission loss of infrared rays.

In addition, according to the present invention, a core crystal fiber and a cladding crystal pipe can be prepared simultaneously. Therefore, the disadvantage can be overcome that a soft core crystal fiber tends to be scratched and the transmission loss is often increased when a core crystal fiber is inserted in a cladding crystal fiber, and moreover, the advantage can be obtained that the length of a fiber to be handled can be made larger than in a batchwise system.

The infrared fiber of the present invention is available for $CO_2$ or CO laser beam waveguides in laser devices for surgical operations such as laser scalpels and laser coagulators, or for infrared waveguides, e.g. to be connected with an infrared detector in a remote alarm system.

The following examples are given in order to illustrate the present invention without limiting the same.

Example 1

A cylindrical system consisting of a high purity mixed crystal of 98% silver bromide and 2% silver chloride was used as an extrusion billet. This billet was charged to a container of an extrusion apparatus and then extruded at a temperature in the range of from 100 to 380°C to form a core crystal fiber with a diameter of 0.5 to 2 mm. A billet consisting of a high purity mixed crystal comprising 98% silver chloride and 2% silver bromide was used as a cladding crystal pipe, charged to a container of an extrusion apparatus provided with a combination die as shown in Fig. 5 and then extruded under similar conditions to those used in forming the core crystal fiber to form a cladding crystal pipe having an outer diameter of 1.0 to 2.5 mm (thickness 0.1—0.5 mm).

Using a 2m length of the resulting crystalline fiber in which a core crystal fiber 1 mm in diameter was inserted in a cladding crystal pipe 1.5 mm in outer diameter (thickness 0.2 mm) with a gap of 0.05 mm, an acrylic resin plate or wood plate was bored or cut by allowing a $CO_2$ gas laser beam with an input of 10 W (wavelength 10.6 μm) to enter one end of the crystalline fiber and focusing it through a converging lens for infrared rays, e.g. a zinc selenide lens.

Example 2

Example 1 was repeated except that KRS-5 was used as the core material and thallium bromide as the cladding pipe material. The extrusion temperature was adjusted to 120 to 350°C, thus obtaining a crystalline fiber with similar dimensions to those of Example 1.

Example 3

Example 1 was repeated except that caesium iodide was used as the core material and caesium bromide as the cladding pipe material. The extrusion temperature was adjusted to 400 to 550°C, thus obtaining a crystalline fiber with similar dimensions to those of Example 1.

Example 4

A cylindrical crystal of high purity silver bromide was used as an extrusion billet, charged to a container, heated, extruded at a temperature in the range of from 100 to 380°C to form a fiber of a silver bromide polycrystal, having a diameter of from 0.5 to 2 mm. This fiber was taken up as a core crystal fiber on a reel. On the other hand, a cylindrical crystal of high purity silver chloride for a cladding crystal was prepared in which a hole for the guide of a combination die (porthole) was made. The cladding crystal, combination die and ram were set in an extrusion container and heated. At a predetermined temperature, the core crystal fiber was passed through the holes of the ram and the guide of the combination die. At an extrusion temperature ranging from 100 to 380°C, a silver chloride pipe with an outer diameter of 1.0 to 2.5 mm (thickness 0.1 to 0.5 mm) was extruded, while at the same time, the core fiber was inserted in the pipe as if caught up therein. In addition, the silver chloride pipe was further coated by extrusion with a protective layer of polyethylene.

The thus obtained infrared fiber having a core diameter of 1 mm and an outer pipe diameter of 1.5 mm (thickness 0.2 mm) was cut to a length of 2 m and used for boring or cutting an acrylic resin plate or wood plate by allowing a $CO_2$ gas laser beam with an input of 10 W (wavelength 10.6 μm) to enter one end of the infrared fiber and to leave the other end thereof and focusing it through a converging lens for infrared rays, e.g. a zinc selenide lens.

**Claims**

1. A crystalline fiber, in which a core crystal fiber for transmitting infrared rays is provided in a cladding crystal pipe having a smaller refractive index than the core crystal with a gap of 0.01 to 0.1 mm between the core crystal fiber and the cladding crystal pipe, the core crystal fiber and cladding crystal pipe being of crystalline materials selected from thallium halide, silver halide, alkali metal halide or mixed crystals thereof in such a combination as to provide the core crystal fiber with a larger refractive index than the cladding crystal pipe.

2. A crystalline fiber as claimed in claim 1 wherein the outer circumference of the cladding crystal pipe is coated with a protective layer of resin or a metal.

3. A process for the production of a crystalline fiber, which comprises inserting a core crystal fiber into a cladding crystal pipe, subjecting the fiber and pipe to drawing through a die and thereby surrounding the core crystal fiber with the cladding crystal pipe such that there is a gap of 0.01 to 0.1 mm between the core crystal fiber and the cladding crystal pipe, the core crystal fiber and cladding crystal pipe being of crystalline materials selected from thallium halide, silver halide, alkali metal halide or mixed crystals thereof in such a combination as to provide the core crystal fiber with a larger refractive index than the cladding crystal pipe.

4. A process as claimed in claim 3 wherein the cladding crystal pipe is obtained by extruding a single crystal or polycrystal of a metal halide through a combination die.          —

5. A process as claimed in claim 3 or claim 4 wherein the drawing is carried out with an area reduction of at the most 20%.

6. A process as claimed in any one of claims 3 to 5 wherein the drawing is carried out with the aid of a lubricant.

7. A process as claimed in any one of claims 3 to 6 wherein the drawing is carried out at a temperature of 100 to 380°C.

8. A process for the production of a crystalline fiber, which comprises preparing a cladding crystal pipe by extrusion and simultaneously inserting a core crystal fiber in the cladding crystal pipe such that there is a gap of 0.01 to 0.1 mm between the core crystal fiber and the cladding crystal pipe, the core crystal fiber and cladding crystal pipe being of crystalline materials selected from thallium halide, silver halide, alkali metal halide or mixed crystals thereof in such a combination as to provide the core crystal fiber with a larger refractive index than the cladding crystal pipe.

9. A process as claimed in claim 8 wherein the extrusion is carried out by the use of a combination die consisting of a die, a porthole with a hole for the passage of the core crystal fiber, a guide which is a hollow protective shaft and an extrusion ram with a hole for the passage of the core crystal fiber, the combination die and the extrusion ram being provided in an extrusion container.

10. A process as claimed in claim 8 or claim 9 wherein the extrusion is carried out at a temperature in the range of from 100 to 380°C.

11. A process as claimed in any one of claims 8 to 10 wherein the core crystal fiber is previously prepared by extrusion.

12. An infrared waveguide comprising a crystalline fiber as claimed in claim 1 or claim 2.

**Patentansprüche**

1. Kristallinische Faser, bei welcher eine Kern-Kristallfaser für den Übertragung von Infrarotstrahlung in einer einkleidenden Kristallröhre vorgesehen ist, die einen geringeren Brechungsindex als der Kernkristall aufweist, wobei ein Spalt von 0,01 bis 0,1 mm zwischen der Kern-Kristallfaser und der einkleidenden Kristallröhre besteht, die Kern-Kristallfaser und die einkleidende Kristallröhre aus kristallinischen Materialien bestehen, die aus Thalliumhalogenid, Silberhalogenid, Alkali-Metall-Halogenid oder gemischten Kristallen dieser in einer derartigen Kombination ausgewählt sind, daß die Kern-Kristallfaser einen größeren Brechungsindex als die einkleidende Kristallröhre aufweist.

2. Kristallinische Faser nach Anspruch 1, wobei der äußere Umfang der einkleidenden Kristallröhre mit einer Schutzschicht aus Harz oder einem Metall beschichtet ist.

3. Verfahren für die Erzeugung einer kristallinischen Faser, das die Schritte umfaßt, einen Kern-Kristallfaser in eine einkleidende Kristallröhre einzuführen, die Faser und die Röhre durch eine Düse zu ziehen und dadurch die Kern-Kristallfaser mit der einkleidenden Kristallröhre dergestalt zu umgeben, daß ein Spalt von 0,01 bis 0,1 mm zwischen der Kern-Kristallfaser und der einkleidenden Kristallröhre besteht, wobei die Kern-Kristallfaser und die einkleidende Kristallröhre aus kristallinischen Materialien bestehen, die aus Thalliumhalogenid, Silberhalogenid, Alkali-Metall-Halogenid oder gemischten Kristallen dieser in einer derartigen Kombination ausgewählt sind, daß die Kern-Kristallfaser mit einem größeren Brechungsindex als die einkleidende Kristallröhre versehen wird.

4. Verfahren nach Anspruch 3, dadurch gekennzeichnet, daß die einkleidende Kristallröhre durch Extrusion eines Einrkistalls oder eines Mehrkristalls eines Metallhalogenids durch eine Kombinationsdüse erhalten wird.

5. Verfahren nach Anspruch 3 oder 4, dadurch gekennzeichnet, daß das Ziehen mit einer Flächenverminderung um höchstens 20% durchgeführt wird.

6. Verfahren nach einem der Ansprüche 3 bis 5, dadurch gekennzeichnet, daß das Ziehen mit der Hilfe eines Schmiermittels durchgeführt wird.

7. Verfahren nach einem der Ansprüche 3 bis 6, dadurch gekennzeichnet, daß das Ziehen bei einer Temperatur von 100 bis 380°C durchgeführt wird.

8. Verfahren für die Herstellung einer kristallinischen Faser, welches Verfahren die Schritte aufweist, eine einkleidende Kristallröhre durch Extrusion herzustellen und zugleich eine Kern-Kristallfaser in die einkleidende Kristallröhre derart einzuführen, daß ein Spalt von 0,01 bis 0,1 mm zwischen der Kernkristallfaser und der einkleidenden Kristallröhre besteht, wobei die Kern-Kristallfaser und die einkleidende Kristallröhre aus kristallinischen Materialien bestehen, die aus Thalliumhalogenid, Silberhalogenid, Alkali-Metal-Halogeniden oder gemischten Kristallen dieser in einer derartigen Kombination ausgewählt werden, daß die Kern-Kristallfaser mit einem größeren Brechungsindex als die einkleidende Kristallröhre versehen wird.

9. Verfahren nach Anspruch 8, dadurch gekennzeichnet, daß die Extrusion durch die Verwendung einer Kombinationsdüse durchgeführt wird, die aus einer Düse, einem Seitenfenster mit einer Ausnehmung für den Druchtritt der Kern-Kristallfaser, einer Führung, die ein hohler Schutzschaft ist, und einem Extrusionskolben besteht, der ein Loch für den Durchtritt der Kern-Kristallfaser aufweist, wobei die Kombinationsdüse und der Extrusionskolben in einem Extrusionsbehälter aufgenommen sind.

10. Verfahren nach einem der Ansprüche 8 oder 9, dadurch gekennzeichnet, daß die Extrusion bei einer Temperatur im Bereich zwischen 100 und 380°C durchgeführt wird.

11. Verfahren nach einem der Ansprüche 8 bis 10, dadurch gekennzeichnet, daß die Kern-Kristallfaser zuvor durch Extrusion hergestellt wurde.

12. Infrarot-Wellenleiter, mit einer kristallinischen Faser, wie sie in den Ansprüchen 1 oder 2 beansprucht ist.

**Revendications**

1. Fibre cristalline, dans laquelle une fibre cristalline d'âme pour la transmission de rayons infrarouges est prévue dans un tube cristallin de gainage ayant un plus faible indice de réfraction que l'âme cristalline avec un interstice de 0,01 à 0,1 mm entre la fibre cristalline d'âme et le tube cristalline de gainage, la fibre cristalline d'âme et le tube cristallin de gainage étant en des matériaux cristallins choisis parmi les halogénures de thallium, les halogénures d'argent, les halogénures de métaux alcalins ou leurs cristaux mixtes en une combinaison de nature à conférer un plus grand indice de réfraction à la fibre cristalline d'âme qu'au tube cristallin de gainage.

2. Fibre cristalline selon la revendication 1 dans laquelle le pourtour extérieur du tube cristallin de gainage est revêtu d'une couche protectrice de résine ou d'un métal.

3. Procédé pour la fabrication d'une fibre cristalline, qui comprend l'insertion d'une fibre cristalline d'âme dans un tube cristallin de gainage, l'application à la fibre et au tube d'un étirage à travers une filière en faisant ainsi entourer la fibre cristalline d'âme par le tube cristalline de gainage de façon qu'il existe un interstice de 0,01 à 0,1 mm entre la fibre cristalline d'âme et le tube cristallin de gainage, la fibre cristalline d'âme et le tube cristalline de gainage étant en des matériaux cristallins choisis parmi les halogénures de thallium, les halogénures d'argent, les halogénures de métaux alcalins ou leurs cristaux mixtes en une combinaison de nature à conférer un plus grand indice de réfraction à la fibre cristalline d'âme qu'au tube cristallin de gainage.

4. Procédé selon la revendication 3 dans lequel on obtient le tube cristallin de gainage par extrusion d'un mono cristal ou d'un polycristal d'un halogénure métallique à travers une combinaison de filière.

5. Procédé selon la revendication 3 ou la revendication 4 dans lequel on effectue l'étirage avec une striction de 20% au plus.

6. Procédé selon l'une quelconque des revendications 3 à 5 dans lequel on effectue l'étirage à l'aide d'un lubrifiant.

7. Procédé selon l'une quelconque des revendications 3, 5 à 6 dans lequel on effectue l'étirage à une température de 100 à 300°C.

8. Procédé de fabrication de fibre cristalline, qui comprend la préparation par extrusion d'un tube cristallin de gainage et simultanément l'insertion d'une fibre cristalline d'âme dans le tuyau cristallin de gainage de façon qu'il existe un interstice de 0,01 à 0,1 mm entre la fibre cristalline d'âme et le tube cristallin de gainage, la fibre cristalline d'âme et le tube de gainage étant en des matériaux cristallins choisis parmi les halogénures de thallium, les halogénures d'argent, les halogénures de métaux alcalins ou leurs cristaux mixtes en une combinaison de nature à conférer un plus grand indice de réfraction à la fibre cristalline d'âme qu'au tube cristalline de gainage.

9. Procédé selon la revendication 8 dans lequel on effectue l'extrusion à l'aide d'une combinaison de filière composée d'une filière, d'une lumière percée d'un trou de passage de la fibre cristalline d'âme, d'un guide qui est tige protectrice creuse et d'un coulisseau d'extrusion percé d'un trou pour le passage de la fibre cristalline d'âme, la combinaison de filière et le coulisseau d'extrusion étant disposés dans un récipient d'extrusion.

10. Procédé selon la revendication 8 ou la revendication 9 dans lequel on effectue l'extrusion à une température comprise entre 100 et 380°C.

11. Procédé selon l'une quelconque des revendications 8 à 10 dans lequel on prépare préalablement par extrusion la fibre d'âme cristalline.

12. Guide d'ondes pour infrarouge comportant une fibre cristalline selon la revendication 1 ou la revendication 2.

# FIG. I

# FIG. 2

(a)

(b)

# FIG. 3

# FIG. 4

1

# FIG. 5

# FIG. 6

## (a)

## (b)

## (c)

FIG. 7

# FIG. 8